(19) Europäisches Patentamt
European Patent Office
Office européen des brevets

(11) EP 0 368 646 B1

(12) **EUROPEAN PATENT SPECIFICATION**

(45) Date of publication and mention
of the grant of the patent:
**05.03.1997 Bulletin 1997/10**

(51) Int Cl.$^6$: **H01L 27/11**

(21) Application number: **89311581.6**

(22) Date of filing: **09.11.1989**

(54) **Semiconductor device**

Halbleiteranordnung

Dispositif semi-conducteur

(84) Designated Contracting States:
**FR GB NL**

(30) Priority: **10.11.1988 JP 284686/88**

(43) Date of publication of application:
**16.05.1990 Bulletin 1990/20**

(73) Proprietor: **SEIKO EPSON CORPORATION**
**Shinjuku-ku Tokyo (JP)**

(72) Inventor: **Kimura, Masakazu**
**Suwa-shi Nagano-ken (JP)**

(74) Representative: **Sturt, Clifford Mark et al**
**J. MILLER & CO.**
**34 Bedford Row,**
**Holborn**
**London WC1R 4JH (GB)**

(56) References cited:
**EP-A- 0 173 245**

- **PATENT ABSTRACTS OF JAPAN, vol. 12, no. 402 (E-673)[3249], 25th October 1988 & JP-A-63 142 669**
- **PATENT ABSTRACTS OF JAPAN, vol. 12, no. 314 (E-649)[3161], 25th August 1988 & JP-A-63 80 566**

## Description

The present invention relates to semiconductor devices and particularly those in which at least one MISFET (Metal Insulator Semiconductor) is formed on a semiconductor substrate and is connected to a high resistance load.

Such a semiconductor device is disclosed in Japanese Patent Laid-Open No. 130461/1982 and. in that disclosure, the load comprises a resistor portion of a single circuit layer. Another such semiconductor devices is disclosed in EP-A-173245.

The MISFET. e.g. a MOSFET (Metal Oxide Semiconductor) and resistor may form part of a memory cell of a high resistivity load type static random access memory (SRAM). The resistance value of the resistor depends upon the material, the cross-sectional area and the length. As smaller and smaller size devices are sought and miniaturisation is of importance, the length available for the resistor becomes the limiting factor in achieving miniaturisation with high resistance. JP-A-63-142669 teaches one way in which the device may be reduced in size. However, this device does not achieve the maximum miniaturisation possible. This limitation on miniaturisation is of particular concern when the cells are part of a matrix with orthogonal word and data lines and the resistor portions are aligned with one of the lines and extend away from the MOSFET to another part of the device. Another similar device is known from JP-A-63 80566.

According to the present invention, there is provided a semiconductor device comprising at least one static memory cell as claimed in claim 1.

This arrangement enables the length of the resistor portion. and hence its total resistance, to be increased, and this in turn enables the size of the semiconductor device to be reduced. Thus whereas it has been impossible to provide the super-high resistivity needed for the resistivity load of a SRAM, the lengthening of the said resistor portion enables the necessary degree of resistivity to be achieved.

Preferably, the first circuit layer extends in one direction from the one electrode to a position over a gate electrode of the MISFET from which position the second circuit layer extends in the opposite direction.

The first circuit layer may be of polysilicide (polycide) or include an intrinsic silicon layer.

The second circuit layer may be a polysilicon layer.

Advantageously. the first circuit layer is extended counter to the direction in which the second circuit layer constituting the resistance load is constructed.

One embodiment of the present invention will hereafter be described, by way of example only, and with reference to the accompanying drawings, in which:-

Figures 1(a) and 1(b) are, respectively, a plan view and a partial sectional view on the line B-B of one embodiment of the invention,

Figures 2(a), 2(b) and 2(c) are partial sectional views similar to figure 1(b) showing different phases during the manufacture of the embodiment of the invention,

Figure 3 is partial sectional view, similar to figure 1 (b) of a prior art semiconductor device;

Figure 4 is a circuit diagram of a configuration of high resistivity polysilicon type memory cell constituting the prior art device and the embodiment of the invention described, and

Figure 5 is a graph indicating the relationship between intrinsic polysilicon resistor sizes and resistance values, measured by the inventor.

In the drawings of the embodiment of the invention and of the prior art device, similar parts are designated by the same reference numerals and further description is omitted to avoid repetition.

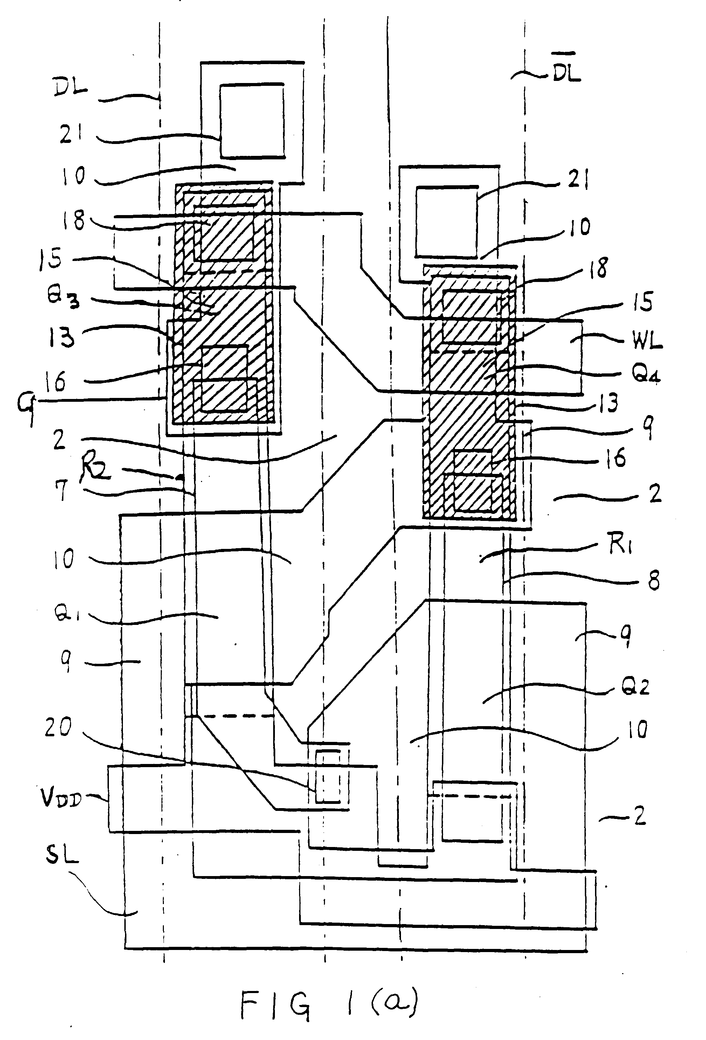

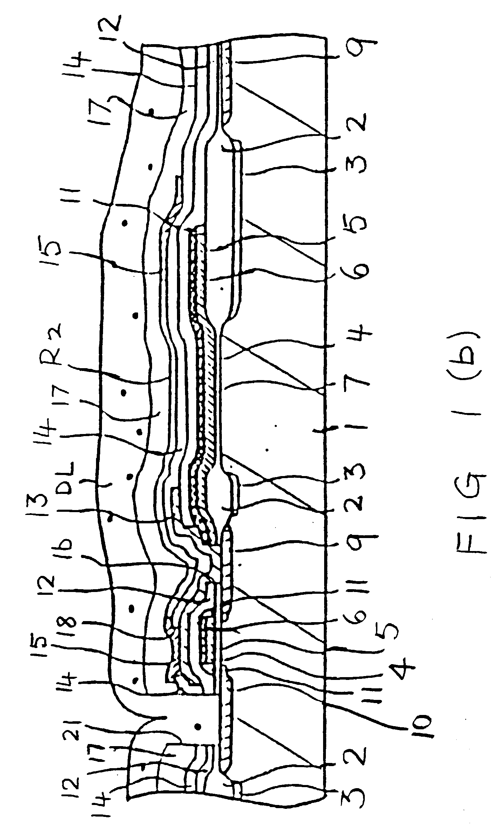

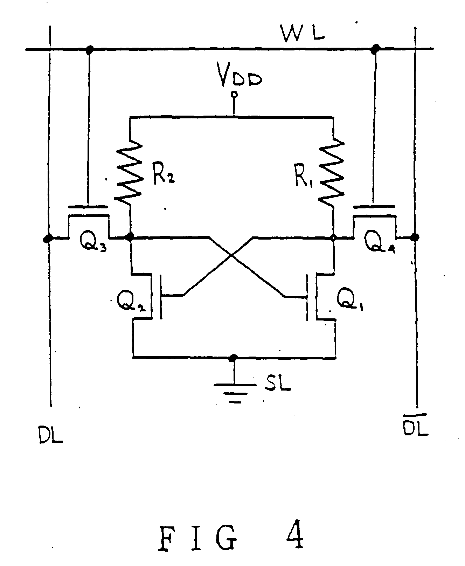

The embodiment of the invention illustrated in Figures 1(a) and 1(b) is a high resistivity polysilicon type memory cell whose circuit diagram is shown in Figure 4 and whose layout, to an enlarged scale, is shown in Figure 1(a).

The circuit diagram (Figure 4) shows a polysilicon memory cell including a pair of MOSFETs Q1 and Q2 whose source electrodes are connected to a ground plane SL, whose gate electrodes are cross-connected to their drain electrodes which are in turn connected through resistors R2 and R1 to a power supply VDD. This flip-flop arrangement is combined with two switching MOSFETs Q3 and Q4 whose source electrodes are connected to the drain electrodes of the MOSFETs Q2 and Q1, respectively, whose drain electrodes are connected to data lines DL and $\overline{DL}$, respectively, and whose gate electrodes are connected to a word line WL.

The cell is formed on and in a semiconductor substrate in the form of a p-type silicon substrate 1. In selected parts of the surface, p-type channel stopper impurity regions 3 are formed as well as source areas 9 and drain areas 10 for the electrodes of the active MOSFETs Q1, Q2, Q3 and Q4. The source and drain areas 9 and 10 are formed by introducing impurities into the substrate 1 in two stages. Each MOSFET also has a gate electrode with a gate insulator 4 in the form of a $SiO_2$ film. A field oxide insulator in the form of a $SiO_2$ film 2 overlies the regions 3 and surrounds the active areas of the MOSFETs. The word line WL consists of a double layer of a polysilicon film 5 and a conductive film 6 of refractory metal or polysilicide (polycide). The word line WL connects the gate electrode of the MOSFET Q3 to the gate electrode of the MOSFET Q4 (Figure 1(a)). The disposition of the source, gate and drain electrodes of the MOSFETs Q3 and Q4 is across the line of the word line WL and aligned with that of the data lines DL and $\overline{DL}$, respectively. The source, gate and drain electrodes of the MOSFETs Q1 and Q2 are disposed across data lines DL and $\overline{DL}$, respectively. The MOSFET Q1 has a gate electrode 7 in the form of a double layer 5, 6 similar to that of the word line WL, which gate electrode extends to the vicinity of the source area 9 of the MOSFET Q3. The MOSFET Q2 has a similar gate electrode 8 which extends to the vicinity of the source electrode 9 of the MOSFET Q4. The source electrode 9 of the MOSFET Q4 extends to the drain electrode 10 of the MOSFET Q1, and the source electrodes 9 of the MOSFETs Q1 and Q2 are extended to form a common ground plane SL. The gate electrode 7 of the MOSFET Q1 extends over the drain electrode 10 of the MOSFET Q2 and is connected thereto through a contact hole 20.

The MOSFETs Q1, Q2, Q3 and Q4 have a lightly doped drain (LDD) structure, the source and drain areas being formed by introducing impurities into the substrate 1 in two stages. After patterning of the word line WL and gate electrodes 7 and 8, side walls 11 therefor are formed of $SiO_2$. An insulating film 12 of $SiO_2$ is laid down over the surface and contact holes 16 are formed to expose portions of the source areas 9 of the MOSFETs Q3 and Q4. A conductive layer 19 of an $n^+$-type polysilicon film is formed thereon and is patterned to a predetermined shape shown in shaded areas 13 in Figure 1(a). Thus each area 13 of the layer 19 extends into the contact hole 16 and connects with the diffusion layer of the source electrode 9 of the respective MOSFET Q3, Q4. Each area 13 of the layer 19 also extends over the insulating film 12 above the word line WL. After patterning of the layer 19, an insulating film 14 is laid down over the surface and contact holes 18 are formed to expose portions of the conductive areas of the layer 13 above and insulated from the gate electrodes of the MOSFETs Q3 and Q4 and the word line WL. Thus, the conductive areas 13 of the layer 19 constitute circuit structure in a first circuit layer.

A second circuit layer 15 of an $n^+$-type polysilicon film is laid down over the surface and enters the contact holes 18. A non-doped or intrinsic polysilicon film is formed overall, the portions to form the resistors R1 and R2 are covered by a mask layer and phosphorus or arsenic is diffused to lower the resistivity of the uncovered portions of the layer 15. The layer is patterned to a predetermined shape which extends above the gate electrodes 7 and 8 and which, beyond the MOSFETs Q1 and Q2, is joined to provide a connection for a power supply VDD. Thus, the parts of the layer 15 which retain their high resistivity and constitute the resistors R1 and R2 extend from adjacent the contact holes 18 to beyond the MOSFETs Q1 and Q2. Thus the resistors are formed in a circuit structure in the second circuit layer.

A sheet resistance value of 150 $\Omega/\square$ or less can be achieved by making the $n^+$-type polysilicon film of the second circuit layer 15 about 1000 Å thick. The actual resistance values are determined by the lengths of the resistors R1 and R2 between the contact holes 18 and the power supply VDD.

Another insulating film 17 which may be a phosphorus-doped silicon glass (PSG) film covers the second circuit layer 15 including the resistors R1 and R2, being deposited overall. Through the insulating layers 17, 14, 12 and 4, contact holes 21 are formed to expose portions of the drain areas 10 of the MOSFETs Q3 and Q4. Data lines DL and $\overline{DL}$ of aluminium film are then provided which extend into the holes 21 to contact the drain electrodes of the MOSFETs Q3 and Q4, respectively. The data lines DL and $\overline{DL}$, in chain dotted lines, overlie the MOSFETs Q3 and Q1 and the MOSFETs Q4 and Q2, respectively.

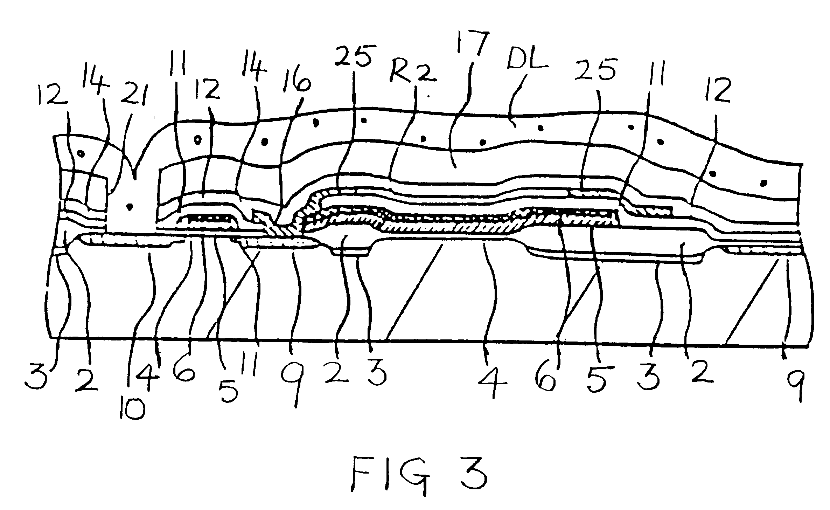

In the prior art cell shown in Figure 3, the same construction is used until the contact holes 16 have been made. After that, a circuit layer 25 of $n^+$-type polysilicon film is formed and shaped to contact the source areas 9 of the MOSFETs Q3 and Q4 through the holes 16. Initially, a non-doped or intrinsic polysilicon film is laid down overall, the portions to form the resistors R1 and R2 are covered by a mask layer and phosphorus or arsenic is diffused to lower the resistivity of the uncovered portions of the layer 25. The same effect may be achieved by ion implantation or other means. After removal of the mask layer, the polysilicon layer 25 is subjected to patterning into predetermined form, thus forming a circuit structure for the semiconductor devices with included resistors. The pattern of the remaining layer 25 is such that it does not extend beyond the source area 9 of the MOSFET and thus the limiting factor in determining the resistance of the resistor is the length between the hole 16 and the power supply VDD.

With the use of two circuit layers, as provided by the present invention, the lengths of the resistors R1 and R2 can be increased, as compared with the prior art resistors, without increasing the size of the cells. This enables higher resistance resistors to be provided without size increase. Alternatively, the length of a cell can be reduced to improve miniaturisation without reducing the resistances of the resistors. Integration density can thereby be increased.

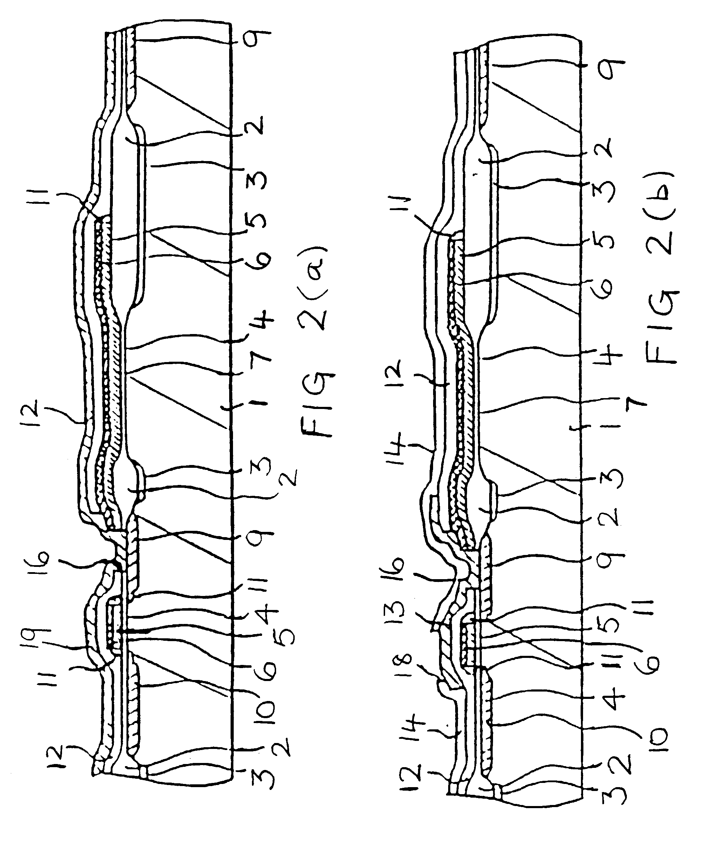

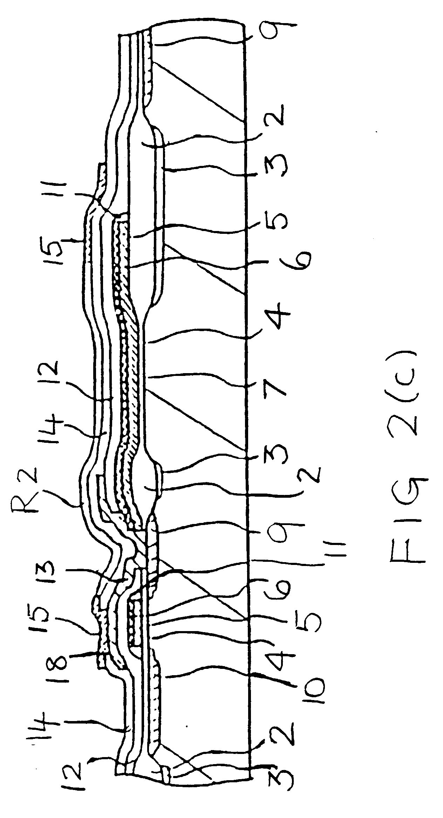

The stages of manufacture will be readily apparent from Figures 2(a), 2(b) and 2(c) of the drawings. The ground plane SL is formed as a diffusion layer in the substrate 1. The layer 19 is formed by chemical vapour deposition as a film of 1000 Å thickness of polysilicon into which an impurity, such as phosphorus or arsenic is diffused, and an ion implanted to obtain low resistivity. With phosphorus, for example, a dose rate of $6 \times 10^{15}$ atoms/$cm^2$ at 30 keV is appropriate. The layer 15 is similarly formed, but is thinner, being a film of 500 Å, so that a lower energy is appropriate. Thus a static RAM with minimised $I_{DDS}$ current is achieved without complicated manufacturing steps.

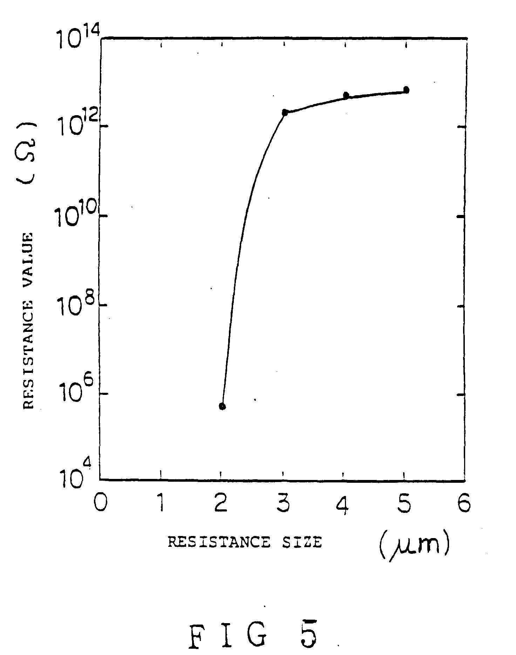

In laying out the form of the cell, the resistance R2 between the MOSFET Q3 and the power supply VDD, is disposed along the line of the data line DL and extended towards the power supply VDD. The resistance value is largely determined by the length of the non-doped or intrinsic polysilicon portion of the layer. Accordingly, the size of the cell (and thus of a memory including a plurality of such cells) is dependent upon the desired resistance values. In "CMOS.SRAM Process Device Art", by Yoshio Sakai, Pages 69 to 114, 28th Semiconductor Special Course Draft, it is shown that, if the lengths of the resistances R1 and R2 are reduced, there is a sudden reduction in resistance (Figure 5) so that, without the invention, high resistances are difficult to obtain when miniaturising a device. Without high resistances, consumption of current on standby increases and a length of about 3μm or more is currently needed, which was a big obstacle to miniaturisation in the absence of the invention.

Whilst a preferred embodiment of the invention has now been described, it will be appreciated that various changes and modifications may be made without departing from the scope of the invention which is defined by the appended claims.

The first circuit layer 19 may be of a refractory metallic silicide film to achieve a low resistance the sheet value being decreased to about 15 Ω/□ or less. This reduces signal delays due to wiring resistance and the layer may be used in input/output circuits other than the memory cell arrangement.

The high resistance polysilicon resistors R1 and R2 are formed so as to cross an end of the first circuit layer at such a position as to maximise the resistance thereof.

## Claims

1. A semiconductor device comprising at least one static memory cell having an area defined by an arrangement of parallel data lines (DL), intersected by a word line (WL) and a power supply line (VDD); each cell formed on a substrate (1) and including:

   at least one MISFET (Q3, Q4) having a source electrode, drain electrode and a gate electrode (4), the gate electrode being connected to the word line;
   a first circuit layer (13) spaced from said substrate by a first insulator (12) and connected to one of the source and drain electrodes (9) of the MISFET through a first contact hole (16); and
   a second circuit layer (15), having a high resistance load (R1, R2), which is connected to said first circuit layer by a second contact hole (18) and spaced therefrom by a second insulator (14), said high resistance load (R1, R2) being spaced from said substrate by at least said first and second insulators (12, 14), characterised in that said second contact hole (18) is disposed at least partially over the gate electrode (4) so that the second circuit layer extends from the second contact hole to the power supply line (VDD).

2. A device as claimed in claim 1, in which the first circuit layer (13) extends in one direction from the one source or drain electrode (9) to the second contact hole (18) from which position the second circuit layer (15) extends in the opposite direction.

3. A device as claimed in claim [or 2. in which the first circuit layer (13) is of polysilicide.

4. A device as claimed in claim 1, 2, or 3 in which the second circuit layer (15) includes an intrinsic silicon layer.

5. A device as claimed in any preceding claim, in which the second circuit layer (15) is a polysilicon layer.

## Patentansprüche

1. Halbleitervorrichtung , umfassend wenigstens eine statische Speicherzelle mit einem Bereich, der durch eine Anordnung von parallelen Datenleitungen (DL) gebildet ist, welche durch eine Wortleitung (WL) und eine Energiezufuhrleitung (VDD) gekreuzt werden, wobei jede Zelle auf einem Substrat gebildet ist und umfaßt:

   wenigstens einen MISFET (Q3, Q4) mit einer Source-Elektrode, eine Drain-Elektrode und einer Gate-Elektrode (4), wobei die Gate-Elektrode mit der Wortleitung verbunden ist,
   eine erste Schaltungsschicht (13), welche von dem Substrat durch einen Isolator (12) in Abstand angeordnet ist und mit einer von Source- und Drain-Elektrode (9) des MISFET durch ein erstes Kontaktloch (16) verbunden ist, und
   eine zweite Schaltungsschicht (15) mit einer Hochwiderstandslast (R1, R2), welche mit der ersten Schaltungsschicht durch ein zweites Durchgangsloch (18) verbunden ist und von dieser durch einen zweiten Isolator (14) in Abstand angeordnet ist, wobei die Hochwiderstandslast (R1, R2) von dem Substrat wenigstens durch die ersten und zweiten Isolatoren (12, 14) in Abstand angeordnet ist, dadurch gekennzeichnet, daß das zweite Kontaktloch (18) wenigstens teilweise über der Gate-Elektrode (4) angeordnet ist, so daß die zweite Schaltungsschicht sich von dem zweiten Kontaktloch zu der Energiezufuhrleitung (VDD) erstreckt.

2. Vorrichtung nach Anspruch 1, worin die erste Schaltungsschicht (13) sich in einer Richtung von der einen Source- oder Drain-Elektrode (9) zu dem zweiten Kontaktloch erstreckt, von welcher Position (18) die zweite Schaltungschicht (15) sich in der entgegengesetzten Richtung erstreckt.

**3.** Vorrichtung nach Anspruch 1 oder 2, worin die erste Schaltungsschicht (13) aus Polysilizid besteht.

**4.** Vorrichtung nach Anspruch 1, 2 oder 3, worin die zweite Schaltungschicht eine intrinsische Siliziumschicht umfaßt.

**5.** Vorrichtung nach einem der vorhergehenden Ansprüche, worin die zweite Schaltungsschicht (15) eine Polysiliziumschicht ist.

**4.** Dispositif selon l'une des revendications 1, 2 ou 3, dans lequel la seconde couche de circuit (15) est constituée par une couche de silicium intrinsèque.

**5.** Dispositif selon l'une quelconque des revendications précédentes, dans lequel la seconde couche de circuit (15) est une couche de polysilicium.

**Revendications**

**1.** Dispositif semi-conducteur comprenant au moins une cellule de mémoire statique ayant une surface définie par une disposition de lignes de données en parallèle (DL) coupées par une ligne de mots (WL) et une ligne d'alimentation (VDD) ; chaque cellule étant formée sur un substrat (1) et comprenant :

au moins un MISFET (transistor à effet de champ métalisolateur-semi-conducteur) (Q3, Q4) ayant une électrode source, une électrode de drain et une électrode de gâchette (4), l'électrode de gâchette étant connectée à la ligne de mots ;
une première couche de circuit (13) espacée dudit substrat par un premier isolateur (12) étant reliée à l'une des électrodes de source et de drain (9) du MISFET par l'intermédiaire d'un premier orifice de contact (16) ; et
une seconde couche de circuit (15) comprenant une résistance de charge élevée (R1, R2), qui est reliée à ladite première couche de circuit par un second orifice de contact (18) et qui en est espacée par un second isolateur (14), ladite résistance de charge élevée (R1, R2) étant espacée dudit substrat par au moins lesdits premier et second isolateurs (12, 14), caractérisé en ce que ledit second orifice de contact (18) est placé au moins partiellement par dessus l'électrode de gâchette (4) de manière que la seconde couche de circuit s'étende du second orifice de contact jusqu'à la ligne d'alimentation (VDD).

**2.** Dispositif selon la revendication 1, dans lequel la première couche de circuit (13) s'étend dans une première direction depuis l'électrode de source ou l'électrode de drain (9) jusqu'au second orifice de contact, et la seconde couche de circuit (15) s'étend à partir de cette position (18) dans la direction opposée.

**3.** Dispositif selon l'une des revendications 1 ou 2, dans lequel la première couche de circuit (13) est en polysiliciure.

FIG 1(a)

FIG I (b)

FIG 2(a)

FIG 2(b)

FIG 2(c)

EP 0 368 646 B1

FIG 3

FIG 4

FIG 5